# DEMANDE DE BREVET EUROPEEN

(11) **EP 1 184 985 A1**
(43) Date de publication de la demande: **06.03.2002**
(21) Numéro de dépôt: 01430023.0
(22) Date de dépôt: 30.07.2001
(51) Int. Cl.: H03K 19/003, G11C 7/22

(54) **Circuit intégré à mémoire comprenant un circuit tampon perfectionné pour la réception d'un signal d'horloge**

(30) Priorité: 23.08.2000 FR 0010873
(71) Demandeur: STMicroelectronics S.A., 92120 Montrouge (FR)
(72) Inventeur: La Rosa, Francesco, 13790 Rousset (FR)
(74) Mandataire: Marchand, André

(57) **Abrégé**

La présente invention concerne un circuit électronique (30) comprenant un plan mémoire (MA), un circuit tampon (20) prévu pour recevoir un signal d'horloge (CLKEXT) et comprenant des moyens de transfert du signal d'horloge, et des moyens pour émettre, en synchronisation avec des fronts descendants et/ou montants du signal d'horloge, des données (DTX) lues dans le plan mémoire. Selon l'invention le circuit tampon comprend des moyens (FED) pour délivrer un signal d'inhibition (INHIB) d'une durée déterminée quand le signal d'horloge (CLKEXT) présente un front descendant et/ou un front montant, des moyens d'inhibition (T1) des moyens de transfert, agencés pour isoler la sortie de l'entrée du circuit tampon lorsque le signal d'inhibition est délivré, et des moyens de mémorisation (I3, T2), agencés pour maintenir à la sortie du circuit tampon la valeur logique (CLK) qui y est présente lorsque le signal d'inhibition est délivré.

## Description

La présente invention concerne un circuit électronique comprenant un plan mémoire, un circuit tampon prévu pour recevoir un signal d'horloge et comprenant des moyens de transfert du signal d'horloge, et des moyens pour émettre, en synchronisation avec des fronts descendants et/ou montants du signal d'horloge, des données lues dans le plan mémoire.

Dans les circuits intégrés comprenant une mémoire, l'émission de données lues dans la mémoire entraîne une baisse temporaire mais significative de la tension d'alimentation, due à un fort appel de courant dans les étages de sortie, notamment dans les amplificateurs de lecture des cellules mémoire.

Une telle baisse de la tension d'alimentation entraîne des erreurs de transmission de données lues dans la mémoire.

La présente invention vise à pallier cet inconvénient.

Le brevet US 5,633,833 décrit en relation avec sa figure 6 un circuit à mémoire comprenant des tampons [60, 70] de réception d'adresse et des moyens d'inhibition des tampons d'adresse sur détection par un circuit ATD [30] ("Adress Transition Detector") d'un changement d'adresse. Les tampons d'adresse et les circuits ATD sont chacun d'une grande complexité et sont en nombre égal au nombre de bits d'adresse à recevoir.

Le brevet US 5,272,674 décrit une structure particulière d'amplificateur de lecture pour cellule mémoire de type EEPROM, comprenant un transistor pour bloquer des données à la sortie de l'amplificateur de lecture, le transistor étant piloté par la sortie d'un deuxième amplificateur de lecture.

Le brevet US 5,200,926 décrit en relation avec ses figures 24 et 25 une mémoire comprenant un tampon de sortie [27] pourvu de moyens d'inhibition pilotés par un signal d'inhibition délivré par un générateur d'impulsions [25].

Ainsi, un objectif de la présente invention est de prévoir une solution simple pour éviter des erreurs de lecture dues à une baisse de la tension d'alimentation pendant une lecture de données synchronisée par un signal d'horloge externe.

Pour atteindre cet objectif, une idée de la présente invention est de prévoir un mécanisme d'inhibition agissant non pas sur les sorties d'un circuit intégré mais sur la réception du signal d'horloge.

Ainsi, essentiellement, la présente invention prévoit un circuit électronique du type décrit ci-dessus dans lequel le circuit tampon comprend : des moyens pour délivrer un signal d'inhibition d'une durée déterminée quand le signal d'horloge présente un front descendant et/ou un front montant, des moyens d'inhibition des moyens de transfert, agencés pour isoler la sortie de l'entrée du circuit tampon lorsque le signal d'inhibition est délivré, et des moyens de mémorisation, agencés pour maintenir à la sortie du circuit tampon la valeur logique qui y est présente lorsque le signal d'inhibition est délivré.

Selon un mode de réalisation, les moyens pour délivrer le signal d'inhibition comprennent une ligne à retard recevant en entrée un signal de référence présentant les mêmes fronts descendants et/ou montants que le signal d'horloge, et une porte logique recevant sur une première entrée la sortie de la ligne à retard et sur une seconde entrée le signal de référence.

Selon un mode de réalisation, les moyens pour délivrer le signal d'inhibition reçoivent en entrée un signal de référence prélevé à la sortie du circuit tampon.

Selon un mode de réalisation, les moyens de transfert comprennent une première et une deuxième portes inverseuses en série et les moyens d'inhibition comprennent un premier interrupteur agencé entre les deux portes inverseuses.

Selon un mode de réalisation, les moyens de transfert comprennent une première et une deuxième portes inverseuses en série, et les moyens de mémorisation comprennent une troisième porte inverseuse recevant en entrée la sortie de la deuxième porte inverseuse, la sortie de la troisième porte inverseuse étant reliée à l'entrée de la deuxième porte inverseuse par l'intermédiaire d'un second interrupteur.

Selon un mode de réalisation, les premier et second interrupteurs sont pilotés par des signaux inverses de manière que le premier interrupteur soit fermé quand le second est ouvert, et réciproquement.

Selon un mode de réalisation, le circuit électronique comprend des moyens pour bloquer les moyens délivrant le signal d'inhibition du circuit tampon.

Selon un mode de réalisation, le signal d'inhibition du circuit tampon n'est émis que pendant des périodes d'émission de données.

Ces objets, caractéristiques et avantages ainsi que d'autres de la présente invention seront exposés plus en détail dans la description suivante d'un exemple de réalisation d'un circuit tampon selon l'invention et de deux exemples d'application de ce circuit tampon, faite en relation avec les figures jointes parmi lesquelles :
- la figure 1 représente schématiquement un circuit intégré comprenant sur son entrée d'horloge un circuit tampon classique,
- les figures 2A à 2D représentent des signaux électriques apparaissant dans le circuit de la figure 1,
- les figures 3A à 3D représentent des signaux électriques apparaissant dans le circuit de la figure 1 lorsque le circuit tampon présente une hystérésis de commutation,
- la figure 4 est le schéma électrique et logique d'un circuit tampon selon l'invention,
- la figure 5 est le schéma électrique d'un élément représenté sous forme de bloc en figure 4,
- les figures 6A à 6E représentent des signaux électriques apparaissant dans le circuit de la figure 1 lorsque le circuit tampon classique est remplacé par un circuit tampon selon l'invention,
- la figure 7 représente schématiquement une mémoire effaçable et programmable électriquement à entrée/sortie série, comprenant un circuit tampon selon l'invention, et
- les figures 8A à 8H représentent des signaux électriques apparaissant dans la mémoire de la figure 7 lorsque des données sont délivrées par la mémoire.

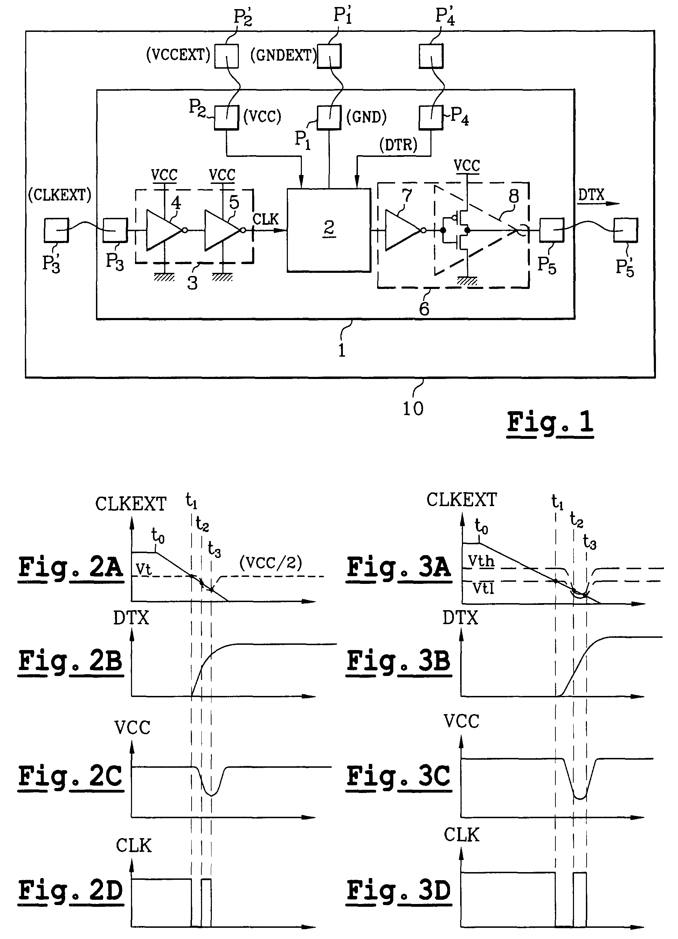

La figure 1 représente un circuit intégré classique 1 agencé sur un support d'interconnexion 10. Le circuit intégré 1 comprend des plages de contact P1 à P5 connectées à des plages P1' à P5' du support 10 par l'intermédiaire de fils métalliques 11 soudés aux ultrasons. La plage P1 reçoit un potentiel de masse GND, la plage P2 reçoit une tension d'alimentation VCC, la plage P3 reçoit un signal d'horloge externe CLKEXT, la plage P4 est prévue pour recevoir des données DTR et la plage P5 est prévue pour émettre des données DTX. En raison de la résistivité des fils 11 et de leur inductance parasite, le potentiel de masse GND présent sur la plage P1 peut, dans des conditions décrites ci-après, être différent du potentiel de masse externe GNDEXT présent sur la plage P1'. De même, la tension d'alimentation VCC reçue sur la plage P2 peut être différente de la tension d'alimentation externe VCCEXT présente sur la plage P2'.

Le signal d'horloge externe CLKEXT reçu sur la plage P3 est appliqué au coeur 2 du circuit intégré (représenté par un bloc) par l'intermédiaire d'un circuit tampon 3 comprenant deux portes inverseuses en cascade 4, 5, dont la sortie délivre un signal d'horloge interne CLK qui recopie les variations du signal d'horloge externe CLKEXT. Les données DTX émises par le coeur 2 du circuit intégré sont délivrées sur la plage P5 par l'intermédiaire d'un tampon de sortie 6 comprenant deux portes inverseuses en cascade 7, 8. La porte inverseuse de sortie 8 comprend un transistor tire-haut 8-1 ("pull-up") de fortes dimensions, capable de délivrer un courant important lors de l'émission d'un "1" en présence d'une charge fortement capacitive. De même, la porte 8 comprend un transistor tire-bas 8-2 ("pull-down") de fortes dimensions, capable de recevoir un courant important lors de l'émission d'un "0" (GND) en présence d'une charge fortement capacitive. Une telle charge capacitive est par exemple un bus de données connecté à la plage P5', présentant une capacité parasite élevée.

Lorsque le circuit intégré 1 émet des données sur la plage P5 en présence d'une charge fortement capacitive, le fort courant sortant lors de l'émission d'un "1" entraîne une chute de tension dans le fil d'alimentation 11 reliant la plage P2 à la plage P2' et une diminution de la tension d'alimentation interne VCC relativement à la tension externe VCCEXT. De même, le fort courant entrant lors de l'émission d'un "0" entraîne une chute de tension dans le fil d'alimentation 11 reliant la plage P1 à la plage P1' et une augmentation du potentiel de la masse interne GND relativement à la masse externe GNDEXT.

Les figures 2A à 2D illustrent les conséquences d'une baisse de la tension VCC au moment de la réception d'un front descendant du signal d'horloge. La figure 2A représente le signal d'horloge CLKEXT reçu sur la plage P3 au moment d'un front descendant et la figure 2D représente le signal d'horloge CLK délivré par la sortie du tampon 3. La figure 2B représente une donnée DTX émise par la plage P5 et la figure 2C représente la tension d'alimentation interne VCC reçue par la plage P2. Sur la figure 2A, le trait pointillé représente le point de basculement Vt des portes inverseuses 4, 5, qui est généralement égal à VCC/2.

A un instant t0, le signal d'horloge CLKEXT présente un front descendant et commence à diminuer. A un instant t1, le signal d'horloge CLKEXT atteint le point de basculement des portes 4, 5 de sorte que la sortie du tampon 3 bascule, le signal d'horloge CLK passant également à 0. Le passage à 0 du signal d'horloge CLK déclenche l'émission d'une donnée, ici une donnée à 1 (fig. 2B), et l'émission de la donnée provoque une baisse significative de la tension VCC (fig. 2C). Il s'ensuit que le point de basculement Vt des portes 4, 5 baisse également (fig. 2A) et devient inférieur au signal d'horloge CLKEXT à un instant t2, de sorte que les portes 4, 5 basculent à nouveau. Le signal d'horloge CLK délivré par le tampon 3 passe ainsi à 1 alors qu'il devrait rester à 0. A un instant t3, la tension d'alimentation VCC remonte, le point de basculement Vt remonte et redevient supérieur au signal d'horloge CLKEXT, et le signal d'horloge CLK repasse à 0.

Ainsi, après le passage à 0 du signal d'horloge externe CLKEXT, on voit apparaître à la sortie du circuit tampon 3 un signal parasite de courte durée. Ce signal parasite risque d'être traité par le circuit intégré comme une impulsion du signal d'horloge ce qui conduira à des erreurs de fonctionnement, par exemple l'émission d'une donnée avant que le "vrai" front descendant suivant du signal d'horloge externe n'apparaisse.

Dans l'art antérieur, il est connu de prévenir ce problème en réalisant des tampons d'entrée au moyen de portes inverseuses à hystérésis de commutation, généralement des triggers de Schmitt inverseurs. De tels inverseurs de Schmitt présentent un seuil de basculement à l'état bas Vtl et un seuil de basculement à l'état haut Vth distincts, le premier étant inférieur au second. Toutefois, selon les constatations faites par la demanderesse, les inverseurs de Schmitt ne permettent pas de supprimer complètement les risques d'émission de signaux parasites. Les figures 3A à 3D représentent l'aspect des signaux des figures 2A à 2D lorsque le tampon d'entrée 3 comprend deux inverseurs de Schmitt en cascade. Il apparaît qu'une forte baisse de la tension d'alimentation VCC (fig. 3C) suite à l'émission d'une donnée à 1 (fig. 3B) peut également, à un instant t2, faire baisser le point de basculement à l'état haut Vth des inverseurs de Schmitt en dessous du niveau du signal d'horloge CLKEXT (fig. 3A). Dans ces conditions, le signal d'horloge interne CLK présente à nouveau une impulsion parasite, qui disparaît à l'instant t3 lorsque le point de basculement à l'état bas Vtl des inverseurs de Schmitt devient supérieur au signal d'horloge externe CLKEXT.

D'autres solutions classiques, mentionnées au préambule, consistent à inhiber pendant la période "critique" les sorties par l'intermédiaire desquelles les données sont émises.

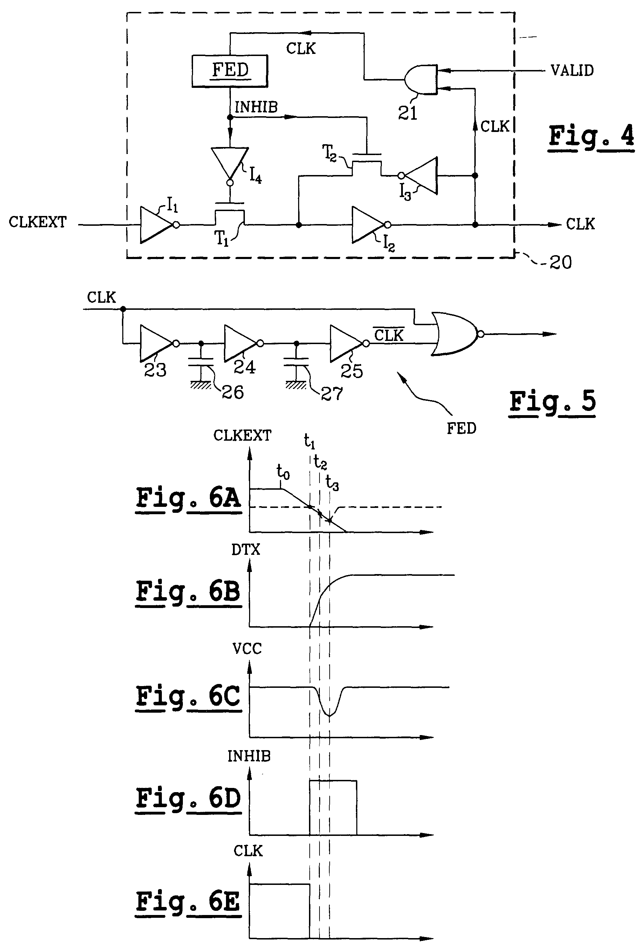

La figure 4 représente un circuit tampon 20 selon l'invention, qui ne présente pas un tel inconvénient. Le circuit 20 comprend classiquement deux portes inverseuses I1, I2 en cascade, l'entrée de la porte I1 recevant un signal d'horloge externe CLKEXT et la sortie de la porte I2 délivrant un signal d'horloge interne CLK. Selon l'invention, le circuit 20 comprend en outre un interrupteur d'inhibition T1, une porte inverseuse de mémorisation I3 et un détecteur de front FED. L'interrupteur d'inhibition T1, ici un transistor MOS, est agencé entre la sortie de la porte I1 et l'entrée de la porte I2. L'entrée de la porte inverseuse I3 est connectée à la sortie de la porte I2 et sa sortie est connectée à l'entrée de la porte I2 par l'intermédiaire d'un interrupteur T2, ici un transistor MOS. Le détecteur de front FED reçoit en entrée le signal CLK prélevé à la sortie du circuit tampon 20 et délivre un signal INHIB appliqué sur la grille du transistor T2. Le signal INHIB est également appliqué sur la grille du transistor T1 par l'intermédiaire d'une porte inverseuse I4. De façon optionnelle, le détecteur de front FED reçoit le signal CLK par l'intermédiaire d'une porte ET 21 recevant en entrée le signal CLK et un signal VALID qui doit être mis à 1 pour que le signal de sortie CLK parvienne à l'entrée du détecteur FED.

Le détecteur FED est ici un détecteur de front descendant prévu pour mettre à 1 le signal INHIB lorsque le signal d'horloge interne CLK présente un front descendant. Une fois mis à 1, le signal INHIB est maintenu à 1 pendant un temps très court, inférieur à la durée séparant les fronts descendants et les fronts montants du signal d'horloge externe CLKEXT.

Comme illustré en figure 5, le détecteur FED comprend par exemple une porte NOR 22 (NON OU) dont la sortie délivre le signal INHIB. La porte 22 reçoit sur une première entrée le signal CLK et sur une deuxième entrée la sortie d'une ligne à retard inverseuse. Cette ligne à retard inverseuse reçoit en entrée le signal CLK et comprend par exemple trois portes inverseuses en cascade 23, 24, 25 et deux capacités électriques 26, 27 connectées respectivement à la sortie de la porte 23 et à la sortie de la porte 24. Lorsque le signal CLK présente une valeur stable égale à 1 ou à 0, le signal INHIB est à 0. Lorsque le signal CLK passe de 1 à 0 (front descendant) la porte 22 reçoit temporairement la valeur 0 sur ses deux entrées jusqu'à ce que la capacité 26 soit chargée et la capacité 27 décharchée. Pendant cette période de courte durée, le signal INHIB est à 1.

Sur la figure 4, il apparaît que le passage à 1 du signal INHIB a pour effet de fermer l'interrupteur T1 (transistor bloqué) et d'ouvrir l'interrupteur T2 (transistor T2 passant). La sortie du circuit tampon 20 se trouve alors isolée de l'entrée du circuit tampon car la porte I1 n'est plus reliée à la porte I2. La valeur du signal CLK est maintenue par la porte I3, qui forme avec la porte I2 une cellule mémoire constituée par deux portes inverseuses agencées tête-bêche. Lorsque le signal INHIB repasse à 0, la sortie de la porte I1 se retrouve connectée à l'entrée de la porte I2 et la sortie du circuit 20 recopie à nouveau le signal CLKEXT.

Les figures 6A à 6E illustrent une application du circuit tampon 20 au circuit intégré 1 représenté en figure 1. Le circuit tampon 20 est agencé en lieu et place du circuit tampon classique 3. La figure 6A représente le signal CLKEXT, la figure 6B représente une donnée DTX émise par le tampon de sortie 6 du circuit intégré 1, la figure 6C représente le profil de la tension d'alimentation VCC, la figure 6D représente le signal INHIB et la figure 6E représente le signal d'horloge interne CLK délivré par le circuit tampon 20.

A l'instant t0, le signal d'horloge externe CLKEXT présente un front descendant et commence à diminuer. A l'instant t1, le signal CLKEXT devient inférieur au point de commutation Vt des portes inverseuses I1, I2 et le signal d'horloge interne CLK passe à 0 (fig. 6E). Le passage à 0 du signal d'horloge interne CLK entraîne l'émission d'une donnée DTX, ici égale à 1 (fig. 6B). L'émission de la donnée DTX entraîne une baisse significative de la tension d'alimentation interne VCC (fig. 6C), qui entraîne elle-même un baisse proportionnelle du seuil de commutation Vt des portes I1, I2. Toutefois, le passage à 0 du signal CLK est détecté par le détecteur FED qui met à 1 le signal INHIB (fig. 6D) et le circuit tampon 20 passe dans un état d'inhibition et de mémorisation de sa sortie. Ainsi, entre les instants t2 et t3, le signal d'horloge interne CLK est maintenu à 0 malgré le fait que le seuil de commutation Vt des portes I1, I2 se trouve en dessous du niveau du signal d'horloge CLKEXT. A un instant t4, le signal INHIB est remis à 0 et le circuit tampon quitte l'état inhibé. La durée d'émission du signal INHIB est égale à (t4 - t1) et correspond au délai imposé par la ligne à retard du détecteur FED.

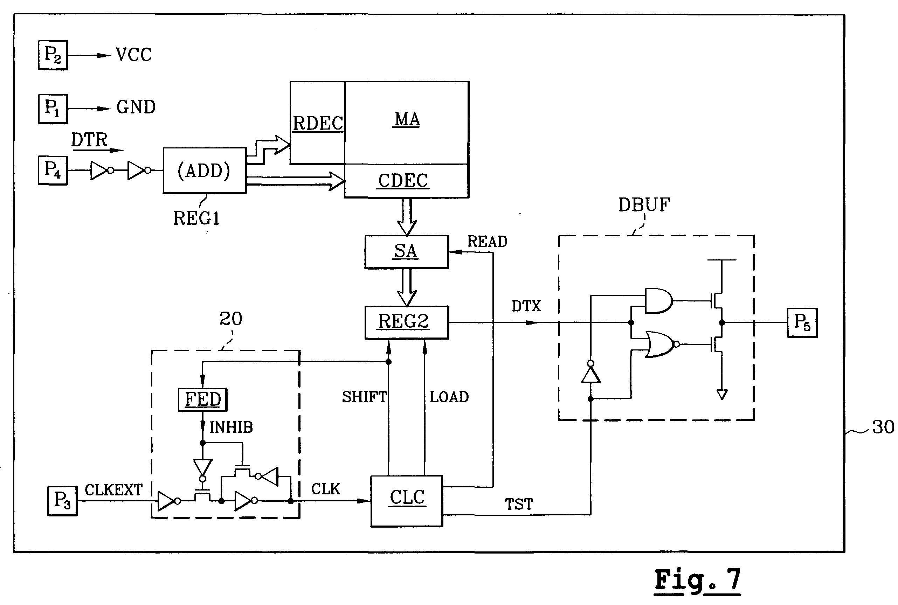

La figure 7 illustre l'application du circuit tampon 20 à une mémoire 30 effaçable et programmable électriquement à entrée/sortie série, destinée à être connectée à un bus de données présentant une forte capacité parasite. La mémoire 30 se présente sous la forme d'une plaquette de circuit intégré comprenant un plan mémoire MA de type EEPROM ou FLASH, dans lequel les cellules mémoire sont agencées en lignes de mots et en lignes de bits, les lignes de bits étant regroupées en colonnes pour former des mots binaires, par exemple des octets. La mémoire 30 comprend des plages de connexion parmi lesquelles on distingue une plage P1 de masse GND, une plage P2 d'alimentation VCC, un plage P3 de réception d'un signal d'horloge externe CLKEXT, une plage P4 de réception de données DTR et une plage P5 d'émission de données DTX.

La mémoire 30 comprend également un décodeur de colonne CDEC connecté aux lignes de bits du plan mémoire MA, un décodeur de ligne RDEC connecté aux lignes de mots, un registre d'entrée REG1, un bloc de lecture SA, un registre de sortie REG2 et un tampon de sortie DBUF. Le registre REG1 est connecté en entrée à la plage P4 par l'intermédiaire d'un circuit tampon classique comprenant deux portes inverseuses. La sortie du registre REG1 délivre respectivement aux décodeurs RDEC et CDEC les bits d'adresse de poids fort et les bits d'adresse de poids faible d'une adresse ADD reçue par l'intermédiaire de la plage P4. Le bloc de lecture SA est connecté en entrée à la sortie du décodeur CDEC. Sur réception d'un signal de lecture READ, le bloc SA délivre sur une entrée parallèle du registre REG2 les huit bits d'un mot binaire d'adresse ADD lu dans le plan mémoire. Le registre REG2 reçoit des signaux de contrôle SHIFT et LOAD et présente une sortie série délivrant des données séries DTX constituées par les bits du mot binaire délivré par le bloc de lecture SA. Plus particulièrement, le registre REG2 charge en parallèle le mot délivré par le circuit SA lorsque le signal SHIFT et le signal LOAD sont conjointement à 1, et délivre un bit du mot binaire sur réception d'un front descendant du signal SHIFT. Enfin, la sortie du registre REG2 est connectée à la plage P5 par l'intermédiaire du tampon de sortie DBUF recevant un signal de contrôle TST. Le tampon DBUF comprend deux étages inverseurs en cascade, le premier étage étant agencé pour placer la sortie du deuxième étage dans l'état haute impédance lorsque le signal TST est égal à 1.

Ces divers éléments sont pilotés par un circuit de contrôle logique CLC qui délivre le signal de lecture READ, les signaux LOAD et SHIFT ainsi que le signal TST. Le circuit CLC est cadencé par un signal d'horloge interne CLK délivré par un circuit tampon 20 selon l'invention, dont l'entrée est connectée à la plage P3. Le circuit tampon 20 est identique à celui décrit précédemment à la seule différence que le détecteur FED reçoit ici en entrée le signal SHIFT au lieu de recevoir le signal CLK.

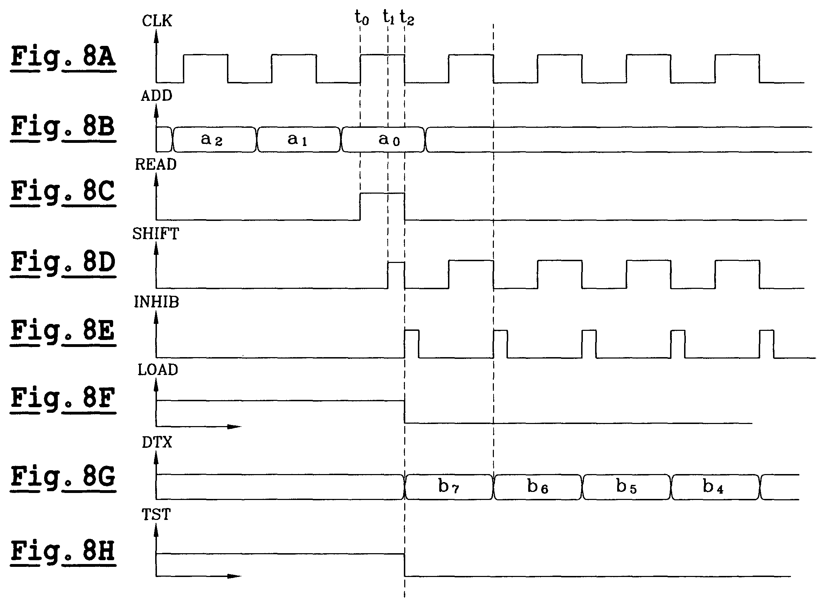

Le fonctionnement de la mémoire 30 en mode lecture est illustré sur les figures 8A à 8H, qui représentent respectivement :
- figure 8A : signal d'horloge interne CLK délivré par le circuit tampon 20,
- figure 8B : bits d'adresse a_{N}, a_{(N-1)}, ... a2, a1, a0 reçus sur la plage P4 et stockés dans le registre REG1,
- figure 8C : signal de lecture READ appliqué au bloc SA,
- figure 8D : signal SHIFT dont la valeur 1 déclenche ici le chargement du registre REG2 (quand le signal LOAD est à 1), et dont le passage à 0 déclenche un décalage d'un rang du registre REG2 et l'émission d'un bit à la sortie du registre,
- figure 8E : signal INHIB délivré par le détecteur FED,
- figure 8F : signal LOAD dont la valeur à 1 autorise le chargement du registre REG2 au moyen du signal SHIFT,
- figure 8G : bits émis par la sortie du registre REG2 (données DTX),
- figure 8H : signal TST d'inhibition du tampon de sortie DBUF.

A un instant t0 correspondant à un front montant du signal d'horloge CLK, le dernier bit d'adresse a0 d'une adresse de lecture ADD est reçu dans le registre REG1 (fig. 8A, 8B) et le signal READ est appliqué au bloc de lecture SA (fig. 8C). A un instant t2, la sortie du bloc de lecture SA s'est stabilisée et le signal SHIFT est mis à 1 (fig. 8D). Le signal LOAD étant également à 1, le registre REG2 charge en parallèle huit bits délivrés par le bloc SA. A un instant t3 correspondant au premier front descendant du signal d'horloge CLK (fig. 8A), les signaux LOAD, SHIFT et TST sont mis à 0 (fig. 8D, 8F, 8H). Le tampon DBUF est transparent et le registre REG2 émet sur sa sortie le premier bit d'un mot binaire, ici un bit de poids fort b7, qui se retrouve sur la plage P5.

Cette étape d'émission d'un bit par le tampon de sortie DBUF1 correspond à la période critique au cours de laquelle la tension d'alimentation VCC peut s'effondrer, entraînant dans l'art antérieur un risque d'émission d'un bit d'horloge erroné. Toutefois, ici, le passage à 0 du signal SHIFT active le détecteur de front FED qui met temporairement à 1 le signal INHIB (fig. 8E). Ainsi, pendant la période critique, le circuit tampon 20 selon l'invention est inhibé et le signal d'horloge interne CLK est maintenu à 0. Au cours des périodes d'horloge suivantes, le signal SHIFT est remis à 1 à chaque front montant du signal d'horloge CLK et est remis à 0 à chaque front descendant du signal d'horloge. Ainsi, à chaque front descendant, les bits suivants b6, b5...b0 du mot binaire sont délivrés par le registre REG2 et à chaque délivrance d'un bit le détecteur FED met à 1 le signal INHIB. La réception du signal d'horloge CLK est donc entièrement sécurisée grâce à la présente invention. En dehors des périodes d'émission de bits en sortie, le signal SHIFT reste à 0 et le circuit tampon 20 selon l'invention n'est jamais inhibé car le détecteur FED reste inactif.

La présente invention est bien entendu susceptible de diverses variantes et modes de réalisation. Bien que l'on se soit attaché à décrire dans ce qui précède un circuit tampon basculant dans un état d'inhibition sur réception d'un front descendant du signal d'horloge, il est possible de prévoir une inhibition sur front montant si des données sont émises à cet instant. Egalement, il est possible de prévoir un circuit tampon basculant dans l'état inhibé après chaque front montant et chaque front descendant du signal d'horloge. Bien que le circuit tampon décrit ci-dessus ait été réalisé à partir de portes inverseuses, qui constituent l'élément de base des circuits logiques, diverses variantes peuvent être envisagées par l'homme de l'art. Notamment, des inverseurs de Schmitt peuvent être utilisés à la place des portes inverseuses, ou tout autre circuit logique permettant de recopier le signal d'horloge externe CLKEXT. Le détecteur FED est également susceptible de diverses variantes de réalisation, une ligne à retard pouvant par exemple être remplacée par une minuterie ("timer"). De plus, dans des circuits intégrés plus complexes comportant un microprocesseur ou des moyens de calcul, le signal INHIB peut être élaboré par le microprocesseur lui-même ou par les moyens de calcul.

## Revendications

1. Circuit électronique (30) comprenant un plan mémoire (MA), un circuit tampon (20) prévu pour recevoir un signal d'horloge (CLKEXT) et comprenant des moyens de transfert du signal d'horloge, et des moyens (CLC, REG2, DBUF) pour émettre, en synchronisation avec des fronts descendants et/ou montants du signal d'horloge, des données (DTX) lues dans le plan mémoire,
**caractérisé en ce que** le circuit tampon comprend :
- des moyens (FED) pour délivrer un signal d'inhibition (INHIB) d'une durée déterminée quand le signal d'horloge (CLKEXT) présente un front descendant et/ou un front montant,
- des moyens d'inhibition (T1) des moyens de transfert, agencés pour isoler la sortie de l'entrée du circuit tampon lorsque le signal d'inhibition est délivré, et
- des moyens de mémorisation (I3, T2), agencés pour maintenir à la sortie du circuit tampon la valeur logique (CLK) qui y est présente lorsque le signal d'inhibition est délivré.

2. Circuit électronique selon la revendication 1, dans lequel les moyens (FED) pour délivrer le signal d'inhibition comprennent une ligne à retard (23-27) recevant en entrée un signal de référence (CLK, SHIFT) présentant les mêmes fronts descendants et/ou montants que le signal d'horloge (CLKEXT), et une porte logique (22) recevant sur une première entrée la sortie de la ligne à retard et sur une seconde entrée le signal de référence (CLK, SHIFT).

3. Circuit électronique selon l'une des revendications 1 et 2, dans lequel les moyens pour délivrer le signal d'inhibition reçoivent en entrée un signal de référence (CLK) prélevé à la sortie du circuit tampon.

4. Circuit électronique selon l'une des revendications 1 à 3, dans lequel les moyens de transfert comprennent une première (I1) et une deuxième (I2) portes inverseuses en série et les moyens d'inhibition comprennent un premier interrupteur (T1) agencé entre les deux portes inverseuses.

5. Circuit électronique selon l'une des revendications 1 à 4, dans lequel les moyens de transfert comprennent une première (I1) et une deuxième (I2) portes inverseuses en série, et les moyens de mémorisation comprennent une troisième porte inverseuse (I3) recevant en entrée la sortie de la deuxième porte inverseuse (I2), la sortie de la troisième porte inverseuse (I3) étant reliée à l'entrée de la deuxième porte inverseuse (I2) par l'intermédiaire d'un second interrupteur (T2).

6. Circuit électronique selon les revendications 4 et 5, dans lequel les premier (T1) et second (T2) interrupteurs sont pilotés par des signaux inverses de manière que le premier interrupteur soit fermé quand le second est ouvert, et réciproquement.

7. Circuit électronique selon les revendications 1 à 6, comprenant des moyens (21) pour bloquer les moyens (FED) délivrant le signal d'inhibition (INHIB) du circuit tampon.

8. Circuit électronique selon l'une des revendications 1 à 7, dans lequel le signal d'inhibition (INHIB) du circuit tampon (20) n'est émis que pendant des périodes d'émission de données.
